# FASCICULE DE BREVET EUROPEEN

(11) **EP 2 036 007 B1**
(45) Date de publication et mention de la délivrance du brevet: **16.01.2013**
(21) Numéro de dépôt: 07729900.6
(22) Date de dépôt: 05.06.2007
(51) Int. Cl.: G06K 19/077

(54) **PROCEDE DE FABRICATION DE CARTES COMPRENANT CHACUNE UN MODULE ELECTRONIQUE ET PRODUITS INTERMEDIAIRES**
VERFAHREN ZUM HERSTELLEN VON KARTEN, DIE JEWEILS EIN ELEKTRONISCHES MODUL UMFASSEN, UND ZWISCHENPRODUKTE
METHOD OF FABRICATING CARDS EACH COMPRISING AN ELECTRONIC MODULE AND INTERMEDIATE PRODUCTS

(30) Priorité: 19.06.2006 EP 06012550
(43) Date de publication de la demande: 18.03.2009
(73) Titulaire: NagraID S.A., 2301 La Chaux-de-Fonds (CH)
(72) Inventeur: DROZ, François, 2035 Corcelles (CH)
(74) Mandataire: Surmely, Gérard
(86) Numéro de dépôt international: PCT/EP2007/055520
(87) Numéro de publication internationale: WO 2007/147727

(56) Documents cités:
- EP-A2- 0 789 323
- US-A- 4 990 759
- US-A- 5 272 374
- US-A1- 2003 226 899
- HAGHIRI YAHYA ET AL: "Vom Plastik zur Chipkarte" VOM PLASTIK ZUR CHIPKARTE: WEGWEISER ZUM AUFBAU UND ZUR HERSTELLUNG VON CHIPKARTEN, XX, XX, 1999, pages 181-192, XP002364832
- FINKENZELLER, KLAUS: "RFID Handbuch" 26 septembre 2002 (2002-09-26), HANSER , MUNICH , XP002447945 ISBN: 3-446-22071-2 page 341 - page 351

## Description

La présente invention concerne un procédé de fabrication de cartes comprenant chacune un module électronique, en particulier un module électronique comprenant un affichage électronique. De préférence, la carte obtenue par le procédé selon l'invention est une carte du type bancaire, en particulier selon la norme ISO. Cependant, la présente invention peut s'appliquer également à des cartes électroniques ayant un profil général autre que rectangulaire, notamment circulaire. La présente invention concerne aussi des produits intermédiaires obtenus dans le cadre du procédé selon l'invention.

Les cartes électroniques ou cartes à circuit intégré ont passablement évolué ces dernières années. Initialement, les cartes électroniques étaient formées d'un corps de carte comprenant un module à contacts résistifs logé dans un évidement de ce corps de carte. Une carte à contact est décrite dans le document US 4,990,759. Cette carte comprend un corps formé de plusieurs couches plastiques laminées et présentant une cavité sensiblement aux dimensions d'un module électronique ayant des contacts électriques sur sa face supérieure. Pour éviter que ce module sorte de la cavité lorsque la carte est pliée, il est prévu qu'une couche supérieure, respectivement de la matière plastique repoussée après introduction du module recouvre partiellement le bord de ce module électronique. Une autre carte à contact est décrite dans le document EP 789 323. Le module électronique comprend d'un côté une face plane munie de contacts électriques et de l'autre côté un circuit électronique enrobé dans une boule de protection. Le corps de la carte comprend une cavité dont les dimensions sont inférieures à celles du module et en particulier à celles de la boule de protection. Ce corps de carte peut être formé par une couche ayant une cavité non traversant ou par deux couches, la première ayant une ouverture et la seconde étant d'épaisseur constante. Le module électronique, le corps de carte et deux films externes sont apportés dans une presse avec le module en face de la cavité ou de l'ouverture. Le module électronique est alors enfoncé à chaud dans la cavité ou l'ouverture, laquelle se déforme et s'agrandit pour épouser le contour du module électronique, et les couches plastiques sont laminées ensemble. La carte est ainsi terminée. On notera que, lors de l'activation de la presse, un surplus de matériau du corps de la carte est déplacé latéralement étant donné que le volume du module électronique est supérieur au volume de la cavité ou de l'ouverture.

Le document US 5,272,374 décrit un procédé de fabrication d'une carte à contacts résistifs externes dans lequel il est prévu de fournir un cadre périphérique comprenant à l'intérieur un cadre secondaire dont l'ouverture est ajustée aux dimensions d'un module électronique. Le procédé comprend les étapes de placement du cadre périphérique dans une coquille inférieure, ensuite de placement du module électronique dans le cadre secondaire de manière que les contacts résistifs soient en contact avec la surface interne de la coquille inférieure, ensuite d'apport d'une coquille supérieure sur la coquille inférieure pour former un moule, et finalement d'injection de matière plastique dans l'ouverture du cadre périphérique, cette matière plastique recouvrant alors la partie arrière du module électronique.

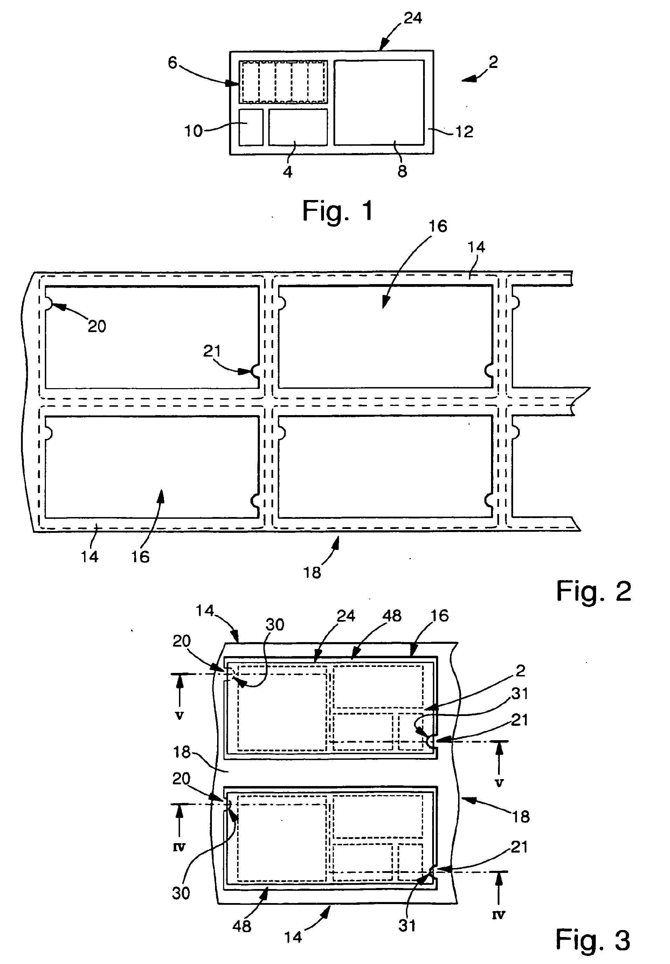

Avec l'évolution du domaine technologique, des cartes sans contact ont été réalisées, c'est-à-dire des cartes comprenant un transpondeur formé d'un circuit électronique relié à une antenne. Avec l'évolution de la carte électronique, on cherche à intégrer d'autres éléments électroniques permettant d'autres fonctions. A titre d'exemple, des cartes comprenant un interrupteur actionnable par l'utilisateur et un affichage électronique ont été divulguées. De telles cartes nécessitent généralement l'agencement de batteries aux dimensions relativement grandes ou de moyens d'alimentation du type cellule photovoltaïque. Pour intégrer ces divers éléments dans une carte, il est généralement prévu de les associer sous la forme d'au moins un module électronique comprenant un support à la surface duquel sont agencés divers éléments électroniques prévus. Un exemple schématique d'un tel module est représenté à la figure 1. Le module 2 comprend un circuit intégré 4 relié à un affichage électronique 6, une batterie 8 et un actionneur 10 agencés sur un support 12 formant un PCB d'interconnexion de ces divers éléments. Pour limiter l'épaisseur de ces modules, on peut prévoir notamment que la batterie et/ou l'affichage soient disposés en périphérie du support 12 ou dans des évidements de celui-ci.

L'intégration dans une carte d'un module électronique relativement encombrant et formé de divers éléments de forme et de dimensions variables n'est pas facilement réalisable. De plus, l'intégration notamment d'un affichage digital, qui doit être positionné précisément dans la carte fabriquée, engendre un problème supplémentaire que se propose de résoudre la présente invention.

Le brevet EP 0 570 784 décrit, dans un mode de mise en oeuvre donné, un procédé de fabrication de cartes sans contact comprenant un ensemble électronique, en particulier un transpondeur qui est placé dans une ouverture principale d'un cadre de positionnement. Selon ce mode de mise en oeuvre, le transpondeur et le cadre de positionnement sont noyés dans un liant pouvant être apporté sous forme de liquide visqueux, notamment une résine. Le cadre de positionnement dans ce document EP 0 570 784 sert uniquement à délimiter une zone interne pour le transpondeur, formé d'un circuit intégré et d'une bobine, à l'intérieur de la carte. Ainsi, lors de l'application d'une pression sur les divers éléments et le liant pour former une carte, le transpondeur est maintenu dans une zone interne alors que le liant, dans un état non solide, a la possibilité de s'étendre pour former une couche traversante de la carte fabriquée. L'homme du métier trouve dans ce document de brevet un procédé permettant d'intégrer dans une carte compacte et plane un module électronique relativement encombrant et de forme complexe. Cependant, le module électronique placé dans l'ouverture principale d'un cadre de positionnement tel que décrit dans ce document subira souvent un léger déplacement lors de la formation de la carte. En effet, ce document ne divulgue pas un maintien du transpondeur dans une position précise et déterminée à l'intérieur de l'ouverture du cadre de positionnement. L'homme du métier pourrait certes penser diminuer les dimensions de l'ouverture principale et les faire correspondre sensiblement aux dimensions du module électronique, en particulier au profil externe de ce module. Toutefois, il est nécessaire de tenir compte des tolérances de fabrication de sorte qu'un ajustement trop serré est difficilement envisageable. De plus, selon la manière dont les modules électroniques sont fabriqués, le positionnement des divers éléments sur le support peut également varier un peu. Ainsi, par exemple, l'affichage digital 6 est agencé à la surface du PCB ou en périphérie de celui-ci dans une position pouvant varier quelque peu. Cependant, pour obtenir une carte de qualité, il est nécessaire de pouvoir positionner précisément cet affichage digital relativement au contour externe de la carte fabriquée. Ceci est particulièrement important lorsqu'il est prévu d'agencer une fenêtre transparente ajustée aux dimensions de l'affichage digital au-dessus de ce dernier pour permettre une lecture par un utilisateur de la carte.

A ce problème de positionnement du module électronique relativement au contour externe de la carte s'ajoute un autre problème lié à l'apport de ce module électronique au sein de l'installation de fabrication de cartes. On notera ici que la fabrication de cartes électroniques s'effectue généralement en lot, c'est-à-dire que plusieurs cartes sont fabriquées simultanément sous forme d'une plaque comprenant une pluralité de modules électroniques. Ensuite, chaque carte est séparée de la plaque obtenue par une étape de découpe, comme cela est décrit dans le document EP 0 570 784. Dans le cadre de cette dernière divulgation, le transpondeur demeure libre relativement au cadre de positionnement jusqu'à ce que la carte soit formée. Ceci demande des précautions dans la manipulation des divers éléments apportés pour former la carte de manière à s'assurer que les transpondeurs demeurent dans les ouvertures correspondantes de la structure de positionnement jusqu'à ce que la presse soit activée.

La présente invention se propose donc également de répondre à ce dernier problème identifié dans le cadre de la présente invention, de manière à simplifier l'apport des modules électroniques tout en garantissant un maintien de ces modules électroniques dans les ouvertures d'une structure de positionnement et de faciliter l'assemblage des divers éléments et matériaux prévus pour la fabrication des cartes.

La présente invention concerne de manière générale un procédé de fabrication d'au moins une carte comprenant chacune un module électronique, ce procédé prévoyant l'apport d'un cadre ou d'une plaque présentant au moins une ouverture prévue pour recevoir au moins ce module électronique. Ce procédé est caractérisé en ce qu'au moins une partie de la région périphérique de ladite au moins une ouverture est déformée ou écrasée par l'application d'une pression, localisée à cette au moins une partie de la région périphérique, sur ledit cadre ou ladite plaque, de manière à réduire localement l'épaisseur dudit cadre ou de ladite plaque dans cette au moins une partie de la région périphérique, en ce que ledit module électronique est apporté en regard de ladite au moins une ouverture de manière qu'au moins une zone de ce module électronique soit superposée à ladite au moins une partie de la région périphérique, et en ce qu'une liaison matérielle est établie entre cette au moins une partie de la région périphérique dudit cadre ou de ladite plaque et ladite au moins une zone dudit module électronique avant l'apport d'une résine au moins d'un côté de ce module électronique dans une étape ultérieure du procédé.

On notera que la carte obtenue par le procédé selon l'invention peut avoir plusieurs unités électroniques indépendantes ou reliées électriquement, lesquels peuvent se trouver dans une seule ouverture d'un cadre ou dans plusieurs ouvertures d'une plaque lors du procédé de fabrication. En particulier, une première unité est un affichage digital, une seconde unité est un circuit électronique et une troisième unité est une batterie. Ces unités peuvent être agencées sur un même support et former ensemble un même module. Toutefois certains éléments peuvent avoir leur propre support ou former une unité distincte reliée à d'autres éléments seulement par les fils ou pattes de connexion électrique. Les divers éléments ou unités d'un module électronique peuvent être nus ou enrobés séparément ou avoir un enrobage commun.

On remarquera que la résine peut être apportée sous différentes formes et dans divers états. Le terme 'résine' doit être compris dans un sens large, incluant les diverses colles connues, les résines PVC et Polyuréthane ou autres résines à disposition de l'homme du métier.

Dans un premier mode principal de mise en oeuvre, le procédé selon l'invention se caractérise par le fait que ladite application d'une pression localisée est effectuée à l'aide d'un outil ou d'une presse avant l'apport dudit module électronique en regard de ladite au moins une ouverture correspondante, ladite au moins une partie déformée ou écrasée définissant au moins une marche sur laquelle est ensuite placée ladite au moins une zone du module électronique.

Dans un deuxième mode principal de mise en oeuvre, le procédé selon l'invention se caractérise par le fait que l'apport dudit module électronique en regard de ladite au moins une ouverture correspondante est effectué avant ladite application d'une pression localisée, ladite au moins une zone du module électronique étant ensuite pressée contre ladite au moins une partie de ladite région périphérique de manière à écraser ou déformer cette au moins une partie et à faire pénétrer ainsi ledit module électronique au moins légèrement plus profondément dans ladite au moins une ouverture.

Les parties de ladite région périphérique du cadre ou de la plaque destinées à être déformées ou écrasées peuvent être formées de divers matériaux et présenter différentes structures. On peut prévoir un PVC classique ou un PVC plus tendre qui se déformera plus facilement sous l'application de ladite pression. On peut aussi prévoir un matériau compressible, par exemple un matériau synthétique ou naturel légèrement expansé, qui sera écrasé localement par l'application de ladite pression.

Dans une variante particulière, le module électronique ou l'ensemble de modules électroniques électriquement reliés est situé dans plusieurs ouvertures séparées par un ou des pont(s) prévu(s) entre les divers éléments ou unités d'un module. La liaison matérielle entre la plaque et le module, respectivement les modules, peut alors être prévue au niveau de ce ou ces pont(s).

Il résulte des caractéristiques du procédé de l'invention que le module électronique de chaque carte est maintenu dans une position déterminée dans au moins une ouverture du cadre ou de la plaque grâce à la liaison matérielle engendrée entre ladite au moins une zone du module électronique et ladite au moins une partie de la région périphérique de ladite au moins une ouverture.

En sélectionnant des matériaux qui adhèrent l'un à l'autre soit par l'application d'une pression, avec ou sans apport de chaleur servant à fondre au moins partiellement l'un ou l'autre, soit par un apport de colle entre cette au moins une zone et cette au moins une partie, on obtient un ancrage du module électronique au cadre qui est suffisant pour assurer le maintien du module électronique dans une position déterminée. Il est ainsi possible de transporter et de déplacer aisément une plaque formant un squelette pour plusieurs cartes avec les modules électroniques logés dans une pluralité d'ouvertures, ce qui facilite grandement l'apport de ces éléments dans l'installation de fabrication de cartes. De plus, cette fixation au moins partielle du bord du module à la région périphérique de l'ouverture correspondante assure également un maintien en position de l'élément électronique dans l'ouverture du cadre tout au long du procédé de fabrication de cartes selon l'invention, en particulier lors de l'apport d'une résine.

Bien que le procédé selon l'invention est déjà réalisable avec une seule partie de la région périphérique du cadre et une zone correspondante du bord du module électronique, il est prévu dans une variante préférée du procédé selon l'invention que l'ouverture du cadre présente des premières dimensions et un premier profil et que le module électronique présente des deuxièmes dimensions et un deuxième profil agencés de manière qu'au moins deux zones distinctes du bord du module électronique soient superposées à deux parties correspondantes de la région périphérique de l'ouverture du cadre, ces deux zones et ces deux parties étant respectivement reliées l'une à l'autre et assurant un positionnement précis du module électronique relativement au cadre.

Selon une variante préférée de l'invention, il est prévu que le module électronique soit sensiblement situé entièrement à l'intérieur de l'ouverture du cadre, ce dernier présentant une épaisseur supérieure ou environ égale à la hauteur maximum du module électronique. De préférence, l'épaisseur du cadre sera sensiblement ajustée à la hauteur maximale du module électronique. L'application de la pression pour déformer ou écraser lesdites parties du cadre est alors effectuée de manière que le module électronique soit sensiblement situé entre la face supérieure et la face inférieure du cadre une fois les zones correspondantes du module assemblées à ces parties du cadre.

L'ensemble, tel que défini à la revendication 21 jointe à la présente description, constitue un produit intermédiaire selon l'invention pour la fabrication de cartes. Cet ensemble est caractérisé par le fait que chaque module électronique a au moins une zone reliée matériellement à au moins une partie de la région périphérique d'une ouverture correspondante de la plaque, ladite au moins une partie de ladite région périphérique formant conjointement avec ladite au moins une zone une liaison matérielle entre ce module électronique et ladite plaque. On remarquera qu'au moins une zone du module et une partie correspondante de la plaque peuvent en outre avoir une fonction supplémentaire de liaison électrique entre le module et un circuit imprimé sur la plaque.

On notera que dans le présent texte, on utilisera soit le terme "cadre", soit le terme "plaque" sans que cela soit limitatif ou exclusif, sauf si le contexte l'indique clairement. L'ensemble protégé est formé généralement par une plaque ajourée et en particulier par un cadre. Le terme "cadre" est utilisé notamment pour le cas particulier où la plaque présente une seule ouverture dans laquelle au moins un module électronique est logé. Dans les autres cas où il y a plusieurs ouvertures, on utilise généralement le terme "plaque". Ainsi notamment pour une carte ayant un seul module électronique dans une ouverture, la plaque forme un cadre plus ou moins large. Toutefois, lorsque l'on parle d'un module électronique dans une ouverture correspondante d'une plaque, cette plaque définit un cadre de positionnement pour ce module.

Selon un mode de mise en oeuvre préféré de l'invention, une résine ou un liant quelconque formant un matériau de remplissage est apporté dans l'espace restant dans les ouvertures de la plaque de l'ensemble susmentionné, de manière à obtenir une structure pleine et sensiblement plane. Selon l'invention, chaque module électronique est matériellement relié au cadre ou à la plaque avant l'apport de la résine. La plaque pleine obtenue selon ce mode de mise en oeuvre peut constituer un produit intermédiaire ou une carte finie. Un produit intermédiaire selon l'invention est défini à la revendication 26 jointe à la présente description. Divers films peuvent être apportés de part et d'autre de ce produit intermédiaire, notamment pour former des couches externes de la carte et/ou des films d'impression.

Dans une variante préférée, le contour de chaque carte est effectué par un découpage final de manière que la plaque ajourée décrite précédemment soit découpée et forme alors au moins partiellement la tranche de la carte dans la zone médiane. Dans une autre variante, le découpage final est effectué à l'intérieur de l'ouverture de sorte que la partie médiane de la tranche de la carte est formée essentiellement par la résine ou le matériau de remplissage. En particulier si le module électronique comprend un support pour les divers éléments, par exemple un PCB, le découpage peut aussi être prévu de manière à découper le substrat dans une région proche de son bord. Dans ce cas, la tranche du support définit en partie la tranche de la carte obtenue.

D'autres avantages et caractéristiques particulières du procédé selon la présente invention et de produits intermédiaires obtenus dans des modes de mise en oeuvre préférés de ce procédé ressortiront également à la lecture de la description suivante, cette description étant faite en référence aux dessins illustratifs, donnés à titre d'exemples nullement limitatifs, dans lesquels :
- la figure 1, déjà décrite, représente schématiquement un module électronique pouvant être intégré dans une carte selon la présente invention;
- la figure 2 représente un premier mode de réalisation d'une plaque formant une pluralité de cadres pour autant de cartes fabriquées selon la présente invention;
- la figure 3 représente partiellement la plaque de la figure 2 dans des ouvertures de laquelle sont situés deux modules électroniques à deux stades différents du procédé selon l'invention;
- les figures 4 et 5 sont des coupes selon les lignes de coupe IV-IV et V-V de la figure 3, représentant respectivement une étape d'un premier mode de mise en oeuvre principal du procédé selon l'invention et un premier mode de réalisation d'un ensemble plaque et éléments électroniques selon l'invention;
- la figure 6 représente schématiquement un deuxième mode de réalisation de l'ensemble plaque et éléments électroniques selon l'invention;
- la figure 7 montre une variante de mise en oeuvre du procédé de l'invention avec l'agencement de plusieurs modules électroniques dans une même ouverture d'une plaque ;
- les figures 8A et 8B montrent chacune un détail de réalisation de la liaison matérielle entre un module électronique et la périphérie de l'ouverture d'une plaque;
- les figures 9A et 9B représentent deux variantes proches du premier mode de réalisation de l'ensemble plaque et modules électroniques;
- la figure 10 représente un troisième mode de réalisation de l'ensemble plaque et modules électroniques pour la fabrication d'une carte selon l'invention ;
- la figure 11 montre schématiquement une variante de mise en oeuvre du procédé de l'invention avec un module électronique agencé dans deux ouvertures ;
- les figures 12A à 12C représentent un deuxième mode de mise en oeuvre principal du procédé selon l'invention ;
- la figure 13 montre un mode de réalisation d'une plaque formant une pluralité de cadres pour autant de cartes fabriquées selon le deuxième mode de mise en oeuvre principal, dans une configuration correspondant à la coupe de la figure 12b ;
- la figure 14A montre un autre mode de réalisation d'une plaque intervenant dans la fabrication de cartes selon le deuxième mode de mise en oeuvre principal de l'invention, au même stade que celle représentée à la figure 13 ;
- la figure 14B montre un mode de réalisation de l'ensemble plaque et modules électroniques avec la plaque représentée à la figure 14A ;
- la figure 15 est une vue partielle en coupe d'une plaque fabriquée selon un mode de mise en oeuvre du procédé de l'invention et formant plusieurs cartes, cette figure 15 montrant approximativement en coupe une région de cette plaque correspondant à une carte; cette plaque constituant en particulier un produit intermédiaire selon l'invention;
- la figure 16 montre en coupe une étape additionnelle d'une variante du premier mode de mise en oeuvre du procédé de l'invention pour obtenir des cartes finies à partir du produit intermédiaire de la figure 15; et
- la figure 17 représente schématiquement et en coupe la formation d'une plaque définissant plusieurs cartes fabriquées selon un mode de mise en oeuvre préféré du procédé selon l'invention.

A l'aide des figures 2 à 5, on décrira ci-après les étapes initiales d'un premier mode de mise en oeuvre principal du procédé selon l'invention. Les cartes fabriquées comprennent au moins un module électronique 2, tel que représenté à la figure 1 de manière schématique et à titre d'exemple uniquement, ainsi qu'un cadre 14 présentant une ouverture 16 agencée pour recevoir le module électronique. A la figure 2 est représenté un premier mode de réalisation d'une plaque 18 formant une pluralité de cadres pour une pluralité correspondante de cartes fabriquées selon l'invention. La plaque 18 comprend ainsi une pluralité d'ouvertures traversantes 16 prévues pour recevoir une pluralité correspondante de modules électroniques. Les traits interrompus définissent les contours extérieurs des cartes fabriquées, lesquelles sont découpées selon ces traits interrompus une fois le procédé de fabrication réalisé pour une pluralité de cartes sous forme de plaque.

On remarquera qu'à la figure 2, la découpe finale est prévue de manière à ce qu'un cadre 14 reste dans la carte et forme ainsi la partie médiane de la tranche extérieure de la carte. Dans une autre variante, on peut prévoir le découpage final à l'intérieur de l'ouverture de sorte que la partie médiane de la tranche de la carte soit essentiellement formée par le matériau de remplissage de l'ouverture.

Comme représenté à la figure 3, chaque ouverture traversante 16 présente de premières dimensions, en particulier une première largeur et une première longueur, et un premier profil qui se distingue par des parties 20 et 21 formant deux saillies relativement au profil général rectangulaire de cette ouverture 16. Ces deux parties 20 et 21 sont situées dans la région périphérique de l'ouverture 16. Le module électronique 2 présente des deuxièmes dimensions, à savoir une deuxième largeur et une deuxième longueur, et un deuxième profil défini par le bord rectangulaire 24.

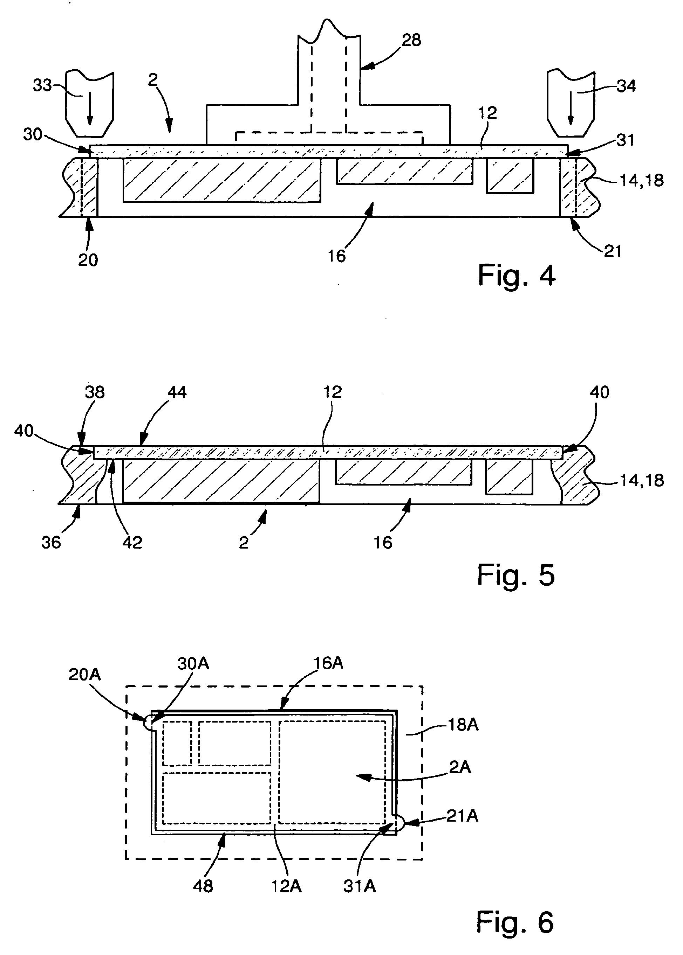

Comme représenté à la figure 4, le module électronique 2 est apporté à l'aide d'un moyen de préhension 28, équipé de moyens d'aspiration engendrant un vide d'air, en regard de l'ouverture 16 du cadre 14. Selon un premier mode de réalisation de l'ensemble plaque médiane et modules électroniques décrit ici, les premières dimensions et le premier profil d'une ouverture 16 sont prévus relativement aux deuxièmes dimensions et au deuxième profil d'un module électronique 2 de manière qu'au moins deux zones distinctes 30 et 31 du bord de ce module électronique soient superposées aux deux parties 20 et 21 correspondantes de la région périphérique de l'ouverture 16. Les zones 30 et 31 sont appliquées contre les parties respectives 20 et 21 pour être ensuite pressées l'une contre l'autre de manière à déformer les parties 20 et 21.

La plaque 18 est formée par exemple en PVC ou d'un autre matériau quelconque approprié. En général, le support 12 du module électronique 2 est formé par un PCB se déformant à une température supérieure à celle à laquelle le matériau formant la plaque 18 se déforme. Toutefois, dans un mode de réalisation particulier, notamment pour assurer une certaine flexibilité au module électronique 2 de grandes dimensions, le support 12 peut également être formé d'un matériau présentant une certaine souplesse et se déformant de manière similaire au PVC.

Selon la variante du procédé décrit à la figure 4, les zones 30 et 31 sont pressées contre les parties 20 et 21 à l'aide de thermodes 33 et 34 permettant de chauffer localement le cadre 14 dans les parties saillantes 20 et 21 et de faire pénétrer le module électronique légèrement plus profondément dans l'ouverture 16 jusqu'à ce que ce module soit sensiblement situé entièrement à l'intérieur de l'ouverture 16, comme représenté à la figure 5. La thermo-compression effectuée à l'aide des thermodes 33 et 34 permet ainsi d'introduire le support 12 dans l'ouverture 16 de sorte que le module 2 est entièrement situé entre la face inférieure 36 et la face supérieure 38 de la plaque 18. La déformation par thermo-compression permet ainsi d'ancrer le module 2 au cadre 14.

Grâce à la pression exercée sur les zones 30 et 31, ces dernières s'enfoncent dans les parties saillantes correspondantes 20 et 21. Une surface d'interface 40 est ainsi formée entre le support 12 et le cadre 14 dans les régions des parties saillantes 20 et 21. Comme cela ressort de la figure 5, cette étape de déformation des parties saillantes 20 et 21, lors de la pénétration des zones 30 et 31 du module 2 dans ces parties, permet de positionner précisément le module électronique relativement au cadre 14 dans l'ouverture 16. Ce positionnement est premièrement latéral et permet notamment de positionner précisément l'affichage électronique 6 relativement au cadre 14. Le positionnement obtenu est également vertical puisque les parties 20 et 21 déformées définissent des butées non seulement au niveau de la tranche du support 12 mais également contre la face inférieure 42 de ce support. Le module électronique est ainsi positionné dans l'ouverture 16 du cadre 14 par les deux zones 30 et 31 qui demeurent solidaire des parties 20 et 21 déformées de manière à épouser le contour de ces deux zones. Ceci permet notamment d'assurer que le module électronique ne ressorte pas de son ouverture lors de manipulation de la plaque 18 représentée à la figure 2 et comprenant dans ses ouvertures 16 des modules électroniques agencés selon ce qui est représenté à la figure 5.

On remarquera que l'ouverture 16 et le module électronique 2 sont agencés de manière à permettre, suite à l'assemblage de ce module électronique au cadre 14 ou à une plaque ajourée, l'introduction d'un matériau de remplissage, notamment une résine, dans un espace restant dans l'ouverture selon un mode de mise en oeuvre préféré du procédé de l'invention

Le mode de mise en oeuvre du procédé décrit ici présente le cas préféré avec plusieurs zones distinctes du bord du module 2 superposées à plusieurs parties saillantes respectives, laissant une fente le long de la majeure partie du bord du module électronique. Cependant, une variante de mise en oeuvre avec une seule zone du bord du module superposée à une seule partie correspondante de la région périphérique de l'ouverture 16 peut également être envisagée dans le cadre de la présente invention. Une telle variante permet déjà d'obtenir certains avantages de l'invention, en particulier un ancrage du module électronique au cadre.

L'adhérence de la surface d'interface 40 peut être augmentée si nécessaire par l'apport au préalable d'un film de colle de faible épaisseur sur les parties 20 et 21 ou sur les zones correspondantes 30 et 31 du côté de la face inférieure 42 du support 12.

Selon d'autres modes de réalisation de l'ensemble plaque ajourée et modules électroniques, la déformation des parties 20 et 21 peut être réalisée sans apport de chaleur. Selon une variante avantageuse, il est prévu qu'au moins les parties 20 et 21 de chaque cadre 14 soient formées d'un matériau facilement déformable de manière plastique. Dans une variante, la déformation est facilitée par l'usage d'ultrasons. Dans une autre variante de réalisation, au moins les parties 20 et 21 sont formées d'un matériau compressible qui est écrasé par lesdites zones du module électronique lors de l'application d'une pression.

De préférence, il est prévu que l'outil de préhension 28 suive le mouvement des thermodes 33 et 34 jusqu'à ce que le module 2 aie entièrement pénétré dans l'ouverture 16, c'est-à-dire que le module 2 reste maintenu par l'outil lors de l'étape de déformation des parties 20 et 21 par l'application d'une pression. Ceci garantit un positionnement très précis du module 2 et également son maintien dans une position horizontale, c'est-à-dire avec le support 12 sensiblement parallèle à la surface supérieure 38 de la plaque 18. Cette dernière caractéristique facilite l'intégration d'un module à contacts électriques relié électriquement au module électronique.

Comme cela est représenté à la figure 5, selon une variante préférée, l'épaisseur du cadre 14 est prévue sensiblement identique à la hauteur maximale du module électronique 2. Ce module est enfoncé dans l'ouverture 16 jusqu'à ce que la surface supérieure 44 du support 12 soit sensiblement confondue avec la face supérieure 38 du cadre 14. Comme cela ressort notamment de la figure 3, les premières dimensions de l'ouverture 16 et les deuxièmes dimensions du module électronique 2 sont prévues de manière qu'une fente 48 demeure entre le bord 24 de ce module et le bord de l'ouverture, et ceci le long de la majeure partie du bord de ce module électronique.

Le module électronique a été représenté avec un substrat à une face duquel sont montés les divers éléments électroniques. Cependant on peut aussi avoir un module avec des pistes ou autres éléments électriques /électroniques situés sur les deux faces du substrat. Dans ce dernier cas il est avantageux de presser le substrat contre les parties saillantes du cadre et de déformer ces dernières jusqu'à ce que le substrat ait pénétré suffisamment dans l'ouverture pour que le module électronique soit situé entièrement à l'intérieur de cette ouverture.

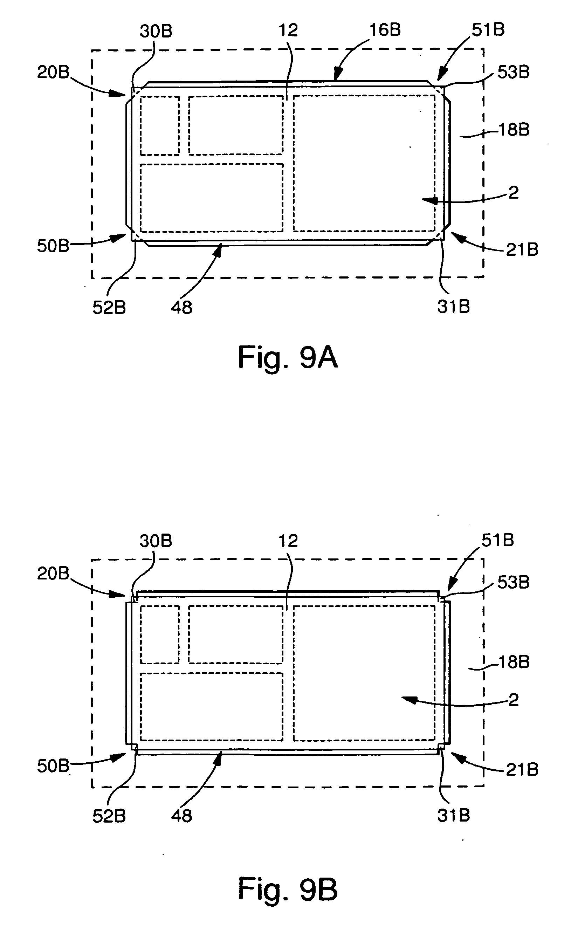

A la figure 6 est représenté un deuxième mode de réalisation de l'ensemble plaque ajourée 18A et modules électroniques 2A. Sur cette figure 6, on a représenté une seule ouverture 16A d'une plaque formant une pluralité de cadres comme représenté à la figure 2. Les dimensions d'une carte finie ont été représentées schématiquement par le trait interrompu externe. Une représentation semblable est utilisée aux figures 9, 10 et 11 par la suite. L'ouverture 16A présente un profil rectangulaire sans partie saillante. Par contre, le substrat 12A du module 2A présente deux zones 30A et 31A formant respectivement deux saillies relativement au profil général externe de ce module, c'est-à-dire ici relativement à son profil rectangulaire. Ces deux zones 30A et 31A du bord du module électronique sont respectivement superposées à deux parties 20A et 21A de la région périphérique de l'ouverture 16A. L'assemblage du module électronique 2A au cadre 14A peut être effectué de manière similaire au procédé de fabrication selon l'invention décrit précédemment.

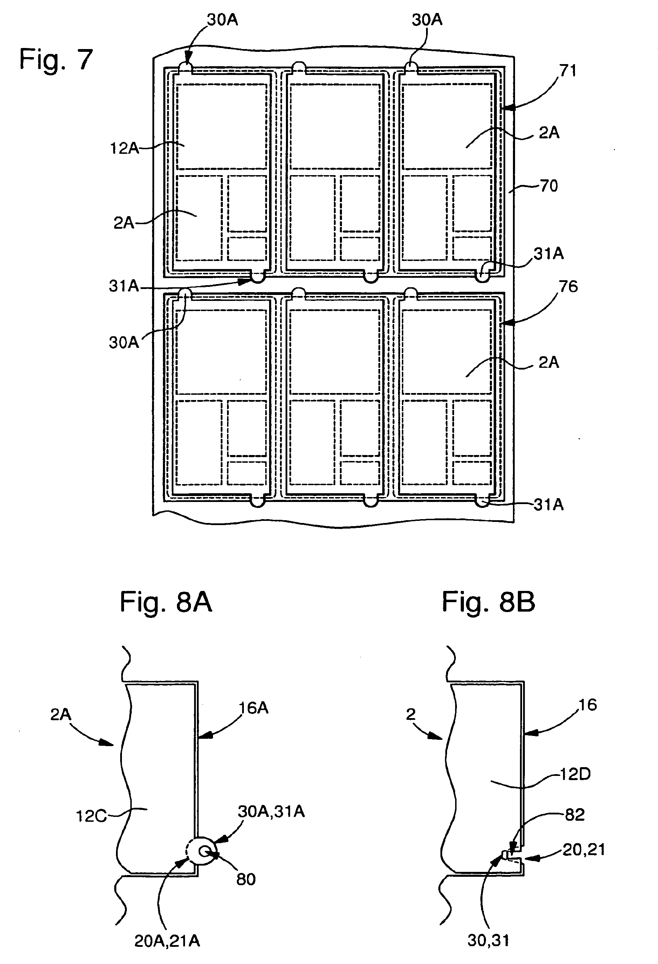

A la figure 7, une variante de mise en oeuvre du procédé est représentée. Elle se distingue par le fait que plusieurs modules électronique 2A sont agencés dans une même ouverture 71 d'une plaque 70. Les zones 30A et 31A du support 12A sont fixées à la région périphérique de l'ouverture 71 comme dans le cas de la figure 6. Le découpage final est prévu dans l'ouverture 71 de sorte que la plaque 70 est entièrement enlevée par ce découpage final. On remarquera que le découpage sectionne les deux saillies 30A et 31A. On peut aussi prévoir un découpage final qui coupe le bord du support 12A sur au moins une partie de son pourtour.

La figure 8A montre une caractéristique particulière permettant d'assurer un meilleur ancrage des zones saillantes 30A et 31A du support 12C du module électronique 2A aux parties 20A et 21A de la région périphérique de l'ouverture 16A. Chaque zone 30A et 31A est pourvue d'un trou 80 dans lequel pénètre partiellement la partie 20A, respectivement 21A lors de la déformation de cette dernière par pression selon le procédé mentionné précédemment. Une variante de réalisation est donnée à la figure 8B pour un mode de mise en oeuvre correspondant à la figure 3. Ici, le support 12D du module électronique 2 est pourvu d'une fente 82 dans les zones 30 et 31 superposées aux parties saillantes 20 et 21 du cadre ou de la plaque. Lors de la déformation de ces parties saillantes par pression selon le procédé mentionné précédemment, ces parties pénètrent partiellement dans les fentes 82 et assure une bonne fixation du module 2 au cadre ou à la plaque.

Aux figures 9A et 9B sont représentées deux variantes du premier mode de réalisation de l'ensemble plaque ajourée et modules électroniques. La plaque 18B présente des ouvertures 16B de forme générale rectangulaire mais avec les quatre angles tronqués définissant quatre parties 20B, 21 B, 50B et 51 B de la région périphérique d'une ouverture. Le support 12 du module 2 a un profil rectangulaire et des dimensions telles que les quatre angles 30B, 31 B, 52B et 53B définissent quatre zones du module 2 superposées respectivement aux quatre angles tronqués de l'ouverture 16B. Une fois le module 2 apporté en face de l'ouverture 16B et positionné correctement relativement au cadre, les quatre coins de support 12 sont pressés contre les quatre parties 20B, 21 B, 50B et 51 B de la plaque pour déformer ces parties de manière similaire au procédé décrit ci-avant pour l'assemblage des modules électroniques à la plaque. Les angles tronqués sont donc déformés et forment des butées pour le support 12 selon les deux dimensions horizontales de l'ouverture 16B et également selon la direction verticale. Les parties des angles tronqués de l'ouverture 16B sont ainsi déformées de manière à épouser la forme des coins du module et permettre ainsi un positionnement stable et précis du module 2 relativement à la plaque 18B. Le long des quatre cotés du module 2 demeure de préférence une fente 48 relativement aux parois latérales de l'ouverture 16B.

La variante de la figure 9B diffère de celle de la figure 9A seulement par le fait que les parties de la région périphérique de l'ouverture superposées aux quatre coins du module 2 sont formées par quatre saillies agencées dans les quatre coins de l'ouverture 16B. Chacune de ces parties saillantes définit un décrochement dans le contour de l'ouverture 16B.

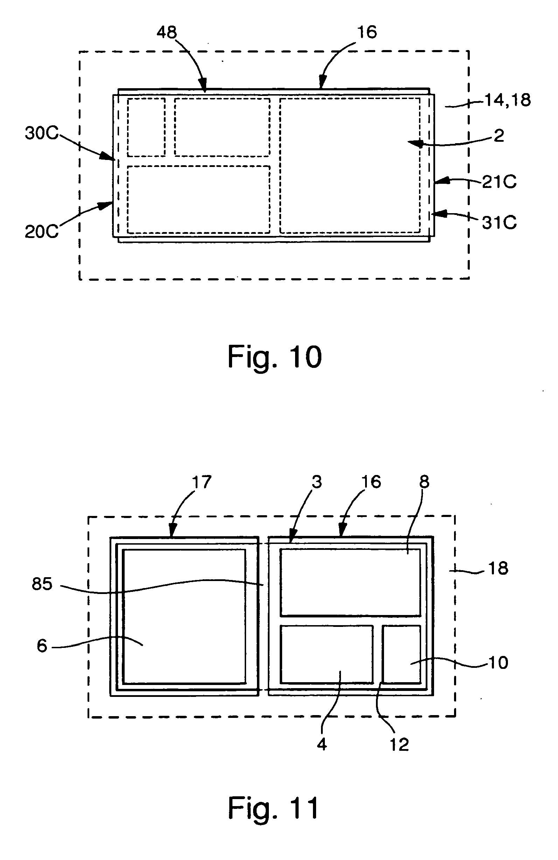

La figure 10 concerne un troisième mode de réalisation de l'ensemble plaque 18 et modules électroniques. Ici, chaque ouverture 16 et le module électronique 2 présente tous deux un profil rectangulaire sans saillie. Une dimension du support 12 est prévue supérieure à la dimension correspondante de l'ouverture 16. Ainsi, les deux zones latérales 30C et 31C sont définies par deux côtés opposés du bord du module 2. Ces deux zones sont respectivement superposées à la région périphérique de l'ouverture 16 définissant deux bords 20C et 21C de l'ouverture rectangulaire 16. Ainsi, comme dans les autres modes de réalisation décrits précédemment, les deux zones 30C et 31C sont pressées contre les parties 20C et 21C pour permettre au module 2 de pénétrer légèrement plus profondément dans l'ouverture 16 et pour assembler le module 2 au cadre 14, respectivement à la plaque 18, de manière que ce module soit sensiblement agencé entièrement dans l'ouverture 16, c'est-à-dire entre les faces supérieure et inférieure du cadre 14, comme représenté à la figure 5. La déformation des parties 20C et 21C est de préférence effectuée par thermo-compression. Toutefois il est envisageable, comme dans les modes de réalisation précédents, d'obtenir cette déformation à température ambiante selon la nature des matériaux utilisés ou par écrasement d'un matériau compressible.

Dans une variante particulière, le bord du support 12 recouvre la région périphérique de l'ouverture 16 du cadre 14 sur les quatre côtés de cette ouverture de sorte que ce support 12 ferme entièrement l'ouverture 16 du côté du support. Dans ce cas l'ouverture 16 est impérativement traversante de sorte qu'une résine peut être introduite dans l'espace restant de l'ouverture depuis le côté du cadre opposé à celui où est agencé le support 12.

On remarquera que les modules électroniques remplissent partiellement les ouvertures correspondantes dans les modes de réalisation représentés aux figures. Ainsi, l'assemblage des modules électroniques à la plaque ajourée est prévu de manière que l'air contenu dans les ouvertures puisse être évacué aisément d'un côté ou de l'autre de la plaque et également de manière à permettre ensuite l'introduction d'un matériau de remplissage, notamment une résine, dans ces ouvertures au moins depuis l'un des deux côtés de cette plaque. De préférence, le profil de chaque ouverture et/ou le module électronique prévu sont agencés de manière à laisser des passages ou fentes traversant l'ensemble selon l'invention. Ainsi, l'air résiduel dans les ouvertures lors de l'apport de la résine peut s'échapper plus aisément et cette résine peut traverser la plaque lors de son introduction dans les ouvertures. Ceci est avantageux pour plusieurs raisons. On évite la formation de poches d'air premièrement lors de l'assemblage des modules électroniques à la plaque ajourée et ensuite lors de l'apport de la résine dans l'espace restant des ouvertures. On empêche aussi que la résine soit comprimée dans les ouvertures et engendre alors des tensions internes qui peuvent ultérieurement provoquer des déformations de surface de la carte finie.

A la figure 11 est représenté un mode de réalisation particulier. Le module électronique 3 comprend les éléments décrits à la figure 1. Entre l'affichage 6 et les autres éléments, le support 12 présente une zone transversale libre. Cette zone est superposée à un pont 85 de la plaque 18, ce pont séparant deux ouvertures 16 et 17. L'affichage 6 est introduit dans l'ouverture 17 alors que les autres éléments sont situés dans l'ouverture 16. Selon le procédé de l'invention, le pont 85 est pressé contre la zone transversale du support de manière à déformer ce pont pour en diminuer son épaisseur et assembler le module 3 à la plaque 18. Selon la terminologie utilisée dans les revendications, on comprend que le pont 85 forme aussi une partie de la région périphérique de chaque ouverture 16, 17. On a représenté le support traversant entre les deux ouvertures prévues pour recevoir le module 3. Cependant il est possible de prévoir le support en deux parties situées respectivement dans les deux ouvertures. Dans ce dernier cas, la liaison matérielle entre le module 3 et le cadre 18 peut être obtenue en pressant le pont 85 contre les fils ou pattes de connexion électrique prévus entre l'affichage 6 et l'autre partie du module 3.

L'ensemble formé par une plaque ajourée et le ou les module(s) électronique(s) relié(s) à cette plaque constitue dans tous les modes de réalisation donnés un produit intermédiaire selon la présente invention.

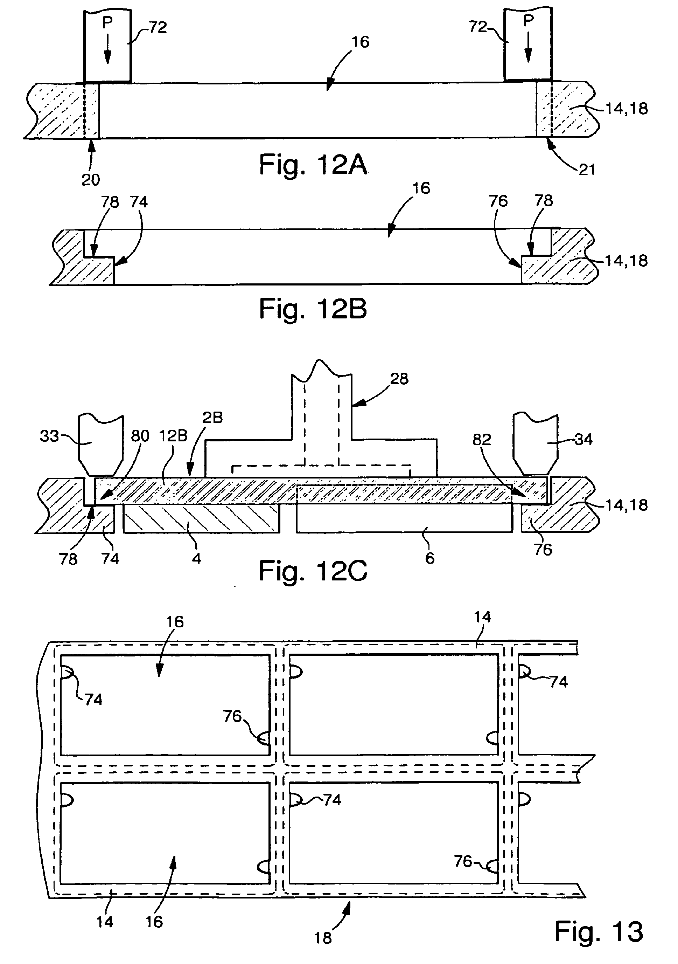

A l'aide des figures 12 à 14, on décrira ci-après un deuxième mode de mise en oeuvre principal du procédé selon l'invention. Selon une première variante décrite aux figures 12A à 12C, ce deuxième mode se distingue essentiellement en ce qu'au moins une partie 20, 21 de la région périphérique de chaque ouverture 16 de la plaque 18, formant une pluralité de cadres 14 pour autant de cartes fabriquées, est déformée ou écrasée par l'application d'une pression à l'aide d'un outil ou d'une presse 72. De préférence l'application de la pression est effectuée à température sensiblement ambiante. On obtient ainsi au moins une languette 74, 76 qui définit une marche, laquelle forme ladite au moins une partie de la région périphérique de l'ouverture 16.

Dans une variante préférée, un film de colle 78 est déposé avant ladite application d'une pression au moins sur les parties saillantes 20 et 21. Le matériau pour la colle est choisi de manière à ce qu'il s'étende lors de la déformation des parties 20 et 21.

Ensuite, un module électronique 2B est apporté dans l'ouverture 16 de manière que des zones 80 et 82 du bord de ce module soient superposées aux languettes préformées 74 et 76 correspondantes. Le module 2B se distingue du module 2 décrit précédemment en ce que son substrat 12B est plus épais et un évidemment est prévu dans ce substrat pour l'agencement de l'affichage 6. Un agencement similaire peut aussi être prévu pour la batterie. A l'aide de l'outil de préhension 28, le module 2B est positionné correctement dans l'ouverture 16. Des thermodes 33 et 34 sont prévues pour chauffer un peu le film de colle 78 de manière à assurer une bonne adhésion des zones 80 et 82 aux languettes 74 et 76. Cependant on notera que d'autres types de colle ne nécessitant pas un apport de chaleur peuvent être utilisés. On mentionnera par exemple les colles UV. Comme pour les autres modes décrits précédemment, la plaque 18 et les modules 2B une fois assemblés forme un ensemble définissant un produit intermédiaire selon l'invention.

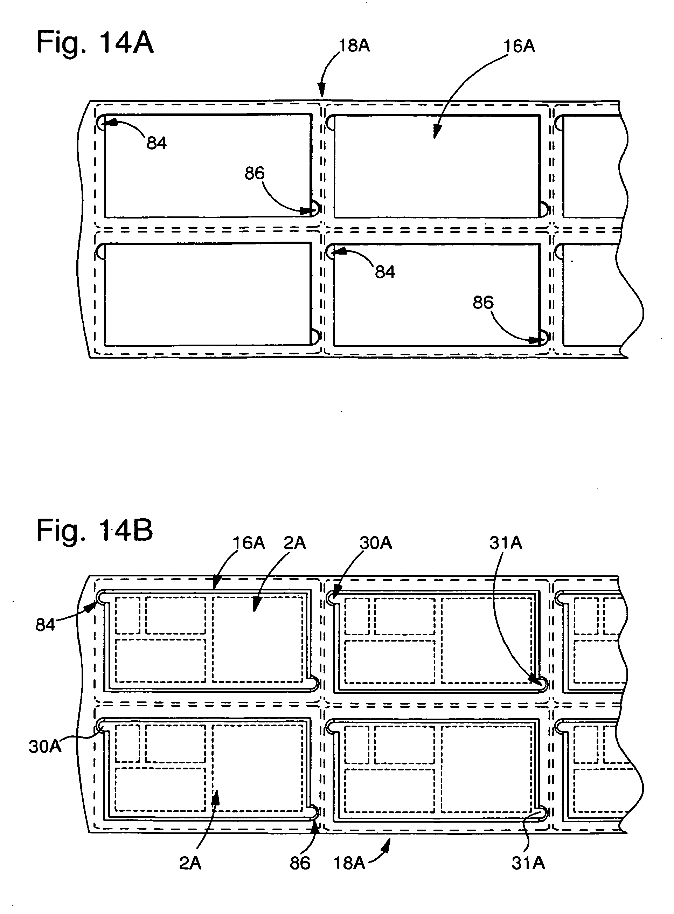

Selon une autre variante du deuxième mode de mise en oeuvre représentée aux figures 14A et 14B, la plaque 18A a des parties 84 et 86 dans la région périphérique de chaque ouverture 16A qui sont écrasées ou déformées par l'application d'une pression de manière similaire à la première variante. Les parties 84 et 86, une fois déformée ou écrasée, forment des encoches à la périphérie des ouvertures 16A. Une fois ces encoches préformées, des modules 2A, ayant des zones saillantes ou languettes 30A et 31A déjà décrites à la figure 6, sont apportés de manière similaire à la première variante dans les ouvertures 16A. Les zones 30A et 31A sont alors placées dans les encoches 84 et 86 correspondantes. A nouveau un film de colle peut être prévu en surface des encoches ou des languettes 30A et 31A. De préférence les encoches ont des dimensions supérieures aux languettes du module de manière à permettre un positionnement précis du module lors de son apport dans l'ouverture. Toutefois, dans une autre variante, on peut prévoir que les dimensions soient ajustées de sorte que les encoches servent au positionnement correct du module relativement au cadre 18A. La plaque 18A et les modules 2A une fois assemblés forme également un ensemble définissant un produit intermédiaire selon l'invention.

Autant les languettes 74,76 que les encoches 84,86 définissent chacune une marche présentant une épaisseur inférieure à celle de la plaque dans laquelle elles sont formées. Toutes les variantes décrites dans le cadre du premier mode de mise en oeuvre principal du procédé selon l'invention s'appliquent par analogie au deuxième mode principal décrit ci-avant.

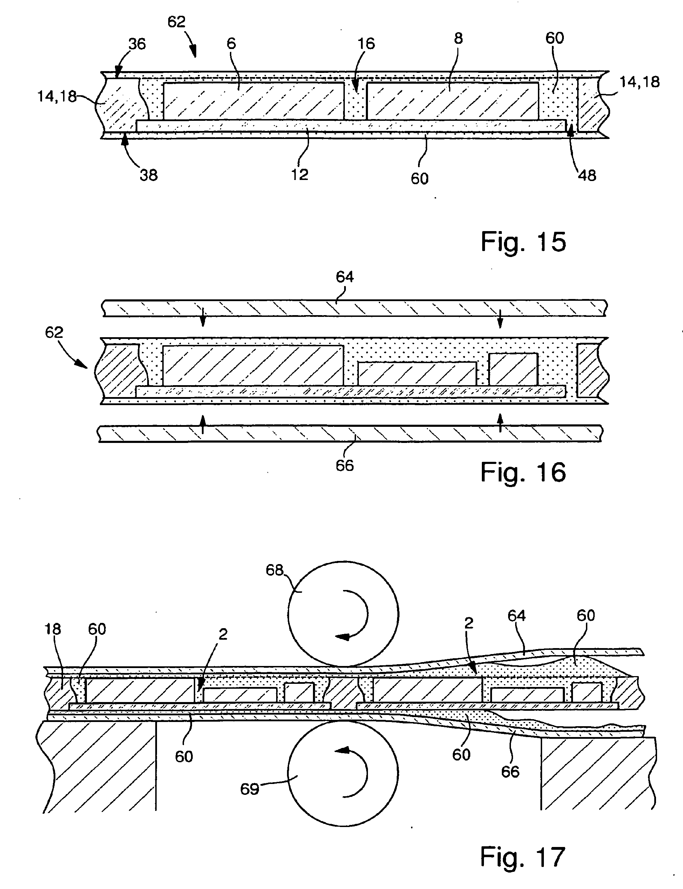

Selon un mode de mise en oeuvre préféré du procédé selon l'invention, une fois l'ensemble plaque et modules électroniques formé, il est prévu d'apporter une résine 60 pour remplir au moins l'espace restant dans les ouvertures. Dans la variante de la figure 15, il est prévu que la résine apportée forme une couche d'une épaisseur supérieure à la hauteur du cadre 14. Les surfaces supérieure et inférieure 36 et 38 sont ainsi recouvertes d'un film mince de résine 60. Cette résine remplit également la fente 48 et forme ainsi une interface d'adhérence entre le cadre 14 et la tranche du support 12. Comme ledit module électronique comprend un affichage électronique 6, il est prévu que la résine 60, au moins dans la région située au-dessus de cet affichage 6, soit transparente.

La formation de la couche de résine 60 peut être effectuée par n'importe quelle technique connue de l'homme du métier, notamment par injection dans un moule, à l'aide d'une presse ou d'au moins un rouleau de laminage. En général, cette résine est apportée après qu'une pluralité de modules électroniques ait été agencée dans une pluralité d'ouvertures correspondantes d'une plaque définissant une pluralité de cadres pour des cartes fabriquées en lot.

La résine 60 peut être constituée par tous matériaux appropriés, notamment une résine polyuréthane, une résine époxy, une colle thermofusible fondue par apport de chaleur, des matériaux thermodurcissables, ou encore des résines durcissant par exposition aux ultraviolets ou en présence d'humidité. Par résine, on comprend tout matériau de remplissage et tout liant connus de l'homme du métier et appropriés à une fabrication de cartes.

La plaque plane 62 obtenue après solidification de la résine apportée, tel que représenté partiellement à la figure 15, peut constituer soit un produit fini après découpe des cartes dans la plaque, soit former un produit intermédiaire à surfaces planes. On notera que la plaque pleine 62, avant découpe des cartes, forme un produit intermédiaire pouvant être utilisé ultérieurement dans la fabrication de cartes présentant des couches ou films externes apportés de part et d'autre de cette plaque 62, comme représenté à la figure 16. Il est également possible de découper la plaque 62 pour obtenir une pluralité de produits intermédiaires sensiblement aux dimensions d'une carte. Dans ce dernier cas, l'apport de couches externes est alors réalisé carte à carte. La figure 16 représente simplement l'apport de deux couches solides 64 et 66 de chaque côté de la plaque plane 62. Ces couches externes 64 et 66 peuvent être apportées et assemblées au produit intermédiaire 62 par un laminage classique ou un collage. De référence, les cartes sont découpées dans la plaque obtenue après l'étape représentée à la figure 16.

Dans une autre variante, la résine apportée remplit sensiblement le volume restant dans l'ouverture 16 sans recouvrir la face supérieure et la face inférieure du cadre ou de la plaque. Dans ce cas, elle peut être apportée seulement du côté du module électronique opposé au substrat. L'homme du métier peut prévoir, lors de la formation de la couche plane 62, des feuilles pas ou peu adhérentes de chaque côté ou d'un seul côté du produit représenté à la figure 15, pour empêcher que la résine colle à la presse ou aux rouleaux lors du procédé de fabrication. Ces feuilles peuvent également protéger le produit lors de manipulations ultérieures ou de transport jusqu'à une installation prévue pour finaliser la carte. Dans le cas d'un produit fini, ces feuilles garantissent une protection de la surface avant une impression ou une vente. Elles sont donc finalement enlevées.

Finalement, la figure 17 représente schématiquement un mode de mise en oeuvre du procédé selon l'invention dans lequel une plaque pleine et plane est formée en pressant, à l'aide de rouleaux de laminage 68 et 69, la résine 60 alors dans un état visqueux et deux couches externes 64 et 66 pour fabriquer une plaque pleine formant une pluralité de cartes. Cette plaque pleine présente une couche centrale, formée par la résine 60 dans laquelle sont compris le cadre 14 et les modules électroniques 2, et deux couches externes de part et d'autre de cette couche centrale. Après solidification de la résine, la plaque pleine peut être découpée au format de cartes bancaires notamment. Toutefois, on notera que d'autres films peuvent encore être apportés dans une étape ultérieure.

On notera que la résine 60 est apportée de préférence en deux étapes, une première partie étant déposée sur la couche inférieure 66 et une seconde partie étant déposée sur l'ensemble formé par la plaque 18 et les modules électroniques 2, comme cela est montré schématiquement à la figure 17.

On remarquera que, lors de l'apport de la résine et en particulier lors de l'étape de laminage décrit schématiquement à la figure 17, les modules électroniques 2 sont parfaitement positionnés relativement aux ouvertures du cadre 18 et maintenus dans cette position malgré la pression exercée par les rouleaux 68 et 69. D'autres moyens de pressage peuvent évidemment être envisagés par l'homme du métier. Comme mentionné ci-avant, dans une variante, les couches externes 64 et 66 peuvent être des feuilles de travail destinées à être enlevées par la suite. Dans ce cas, ces couches externes sont prévues peu adhérentes à la résine 60.

## Revendications

1. Procédé de fabrication d'au moins une carte comprenant chacune un module électronique (2;2A;2B;3), ce procédé prévoyant l'apport d'un cadre (14) ou d'une plaque (18;18A;18B;70) présentant au moins une ouverture traversant (16;16A;16B;71) dans laquelle ledit module électronique est introduit, ainsi que l'apport d'un matériau de remplissage (60) pour remplir un espace restant dans ladite au moins une ouverture traversant, ce procédé étant **caractérisé en ce qu'**au moins une partie (20,21; 20A,21A; 20B,21B; 20C,21C; 85) de la région périphérique de ladite au moins une ouverture est déformée ou écrasée par l'application d'une pression, localisée à cette au moins une partie de la région périphérique, sur ledit cadre ou ladite plaque, de manière à réduire localement l'épaisseur dudit cadre ou de ladite plaque dans cette au moins une partie de la région périphérique, **en ce que** ledit module électronique est apporté en regard de ladite au moins une ouverture de manière qu'au moins une zone (30,31; 30A,31A; 30B,31B; 30C,31C) de ce module électronique est superposée à ladite au moins une partie de la région périphérique, et **en ce qu'**une liaison matérielle est établie entre cette au moins une partie de la région périphérique dudit cadre ou de ladite plaque et ladite au moins une zone dudit module électronique avant l'apport dudit matériau de remplissage (60) dans une étape ultérieure du procédé.

2. Procédé selon la revendication 1, **caractérisé en ce que** ladite application d'une pression localisée est effectuée à l'aide d'une presse (72) avant l'apport dudit au moins un module électronique en regard de ladite au moins une ouverture, ladite au moins une partie déformée ou écrasée définissant au moins une marche (74, 76) sur laquelle est ensuite placée ladite au moins une zone du module électronique.

3. Procédé selon la revendication 1, **caractérisé en ce que** l'apport dudit module électronique en regard de ladite au moins une ouverture correspondante est effectué avant ladite application d'une pression localisée, ladite au moins une zone du module électronique étant ensuite pressée contre ladite au moins une partie de ladite région périphérique de manière à écraser ou déformer cette au moins une partie et à faire pénétrer ainsi ledit module électronique au moins légèrement plus profondément dans ladite au moins une ouverture.

4. Procédé de fabrication selon l'une des revendications précédentes, **caractérisé en ce que** ledit module électronique comprend un élément d'affichage électronique (6).

5. Procédé selon l'une des revendications précédentes, **caractérisé en ce que** ladite application d'une pression localisée est effectuée sans apport de chaleur localisé à ladite au moins une partie de la région périphérique dudit cadre ou de ladite plaque.

6. Procédé selon la revendication 5, **caractérisé en ce que** ladite application d'une pression localisée est effectuée sensiblement à température ambiante.

7. Procédé de fabrication selon l'une des revendications 1 à 4, **caractérisé en ce que** ladite déformation de ladite partie de la région périphérique de ladite au moins une ouverture est obtenue par une thermo-compression localisée.

8. Procédé de fabrication selon l'une des revendications précédentes, **caractérisé en ce qu'**au moins une dite zone ou une dite partie de la région périphérique de ladite au moins une ouverture est enduite de colle (78), avant assemblage dudit module électronique avec ledit cadre ou ladite plaque, pour former un film d'adhérence entre cette zone et la partie correspondante.

9. Procédé de fabrication selon l'une des revendications précédentes et dans lequel ledit module électronique est agencé dans une seule ouverture, cette ouverture ayant des premières dimensions et un premier profil et ce module électronique ayant des deuxièmes dimensions et un deuxième profil, **caractérisé en ce que** lesdites premières dimensions et ledit premier profil de cette ouverture et lesdites deuxièmes dimensions et ledit deuxième profil de ce module électronique sont prévus de manière qu'au moins deux zones distinctes dudit bord du module électronique soient superposées à autant de parties correspondantes de ladite région périphérique de l'ouverture, l'application d'une pression localisée étant effectuée sur ces parties correspondantes, chacune des zones et la partie qui lui correspond formant une liaison rigide entre le module électronique et le cadre ou la plaque après assemblage de ces deux éléments.

10. Procédé selon la revendication 9, **caractérisé en ce que** ladite au moins une partie de ladite région périphérique est formée par une saillie (20,21) relativement au profil général de ladite au moins une ouverture.

11. Procédé selon la revendication 9, **caractérisé en ce que** ladite au moins une partie de la région périphérique est formée par un angle tronqué de ladite ouverture ou par une partie angulaire saillante (20B,21 B) relativement au profil général de cette ouverture.

12. Procédé selon l'une des revendications 9 à 11, **caractérisé en ce que** ladite au moins une zone du bord dudit module électronique est formée par une saillie (30A,31A) relativement au profil général externe de ce module électronique.

13. Procédé selon l'une des revendications 9 à 12, **caractérisé en ce que** lesdites premières dimensions, ledit premier profil, lesdites deuxièmes dimensions et ledit deuxième profil sont prévus de manière qu'une fente (48) demeure entre ledit module électronique et ladite ouverture le long de la majeure partie dudit bord de ce module électronique.

14. Procédé selon l'une des revendications précédentes, **caractérisé en ce que** l'épaisseur dudit cadre ou de ladite plaque est prévue sensiblement identique à la hauteur maximale dudit module électronique, ce module électronique étant agencé dans ladite au moins une ouverture de manière à ce qu'il soit sensiblement situé entièrement entre le plan inférieur et le plan supérieur définit par ledit cadre ou ladite plaque.

15. Procédé selon l'une des revendications précédentes, **caractérisé en ce qu'**une résine (60) est apportée pour former une couche incorporant ledit cadre ou ladite plaque et ledit module électronique de chaque carte.

16. Procédé selon la revendication 15, **caractérisé en ce que** ledit matériau de remplissage est constitué par ladite résine.

17. Procédé selon la revendication 15 ou 16, **caractérisé en ce que** la surface inférieure et la surface supérieure dudit cadre ou de ladite plaque sont recouvertes par ladite résine.

18. Procédé selon l'une des revendications 15 à 17, **caractérisé en ce que** le produit obtenu constitue un produit intermédiaire présentant une face inférieure et une face supérieure qui sont sensiblement planes.

19. Procédé selon la revendication 17, **caractérisé en ce qu'**au moins deux couches solides sont respectivement apportées des deux côtés de ladite plaque ouverte assemblée à des modules électroniques et de ladite résine alors dans un état visqueux, chaque carte obtenue après solidification de ladite résine présentant ainsi deux couches externes.

20. Procédé selon la revendication 4 et l'une des revendications 15 à 19, **caractérisé en ce que** ladite résine recouvre ledit élément d'affichage et **en ce qu'**elle est prévue transparente.

21. Ensemble pour un procédé de fabrication de cartes dans lequel cet ensemble est premièrement formé et ensuite recouvert au moins partiellement par un matériau de remplissage ou une résine pour former avec ce matériau de remplissage ou cette résine une couche des cartes, cet ensemble étant **caractérisé en ce qu'**il est formé d'une plaque (18;18A;18B;70) présentant une ou plusieurs ouverture(s) traversant (16;16A;16B;71), un ou plusieurs module(s) électronique(s) (2;2A;2B;3) étant logé(s) dans cette ou ces ouverture(s) qui présente(nt) chacune un espace restant ouvert au moins d'un côté de ladite plaque, chaque module électronique ayant au moins une zone (30,31; 30A,31A; 308,31B; 30C,31C) superposée et fixée à au moins une partie (20,21; 20A,21A; 20B,21B; 20C,21C; 85) de la région périphérique d'une ouverture correspondante de la plaque, ladite au moins une zone et ladite au moins une partie formant ainsi conjointement une liaison matérielle entre ce module électronique et ladite plaque, et **en ce que** ladite au moins une partie de la région périphérique de chaque ouverture présente une hauteur inférieure à l'épaisseur de ladite plaque.

22. Ensemble selon la revendication 21, **caractérisé en ce que** chaque ouverture de ladite plaque présente des premières dimensions et un premier profil et chaque module électronique présente des deuxièmes dimensions et un deuxième profil qui sont prévus de manière qu'au moins deux zones distinctes du bord de ce module électronique soient superposées à au moins deux parties correspondantes de ladite région périphérique de l'ouverture correspondante, chaque zone et la partie correspondante formant conjointement une liaison matérielle entre ce module électronique et ladite plaque et assurant ainsi le positionnement du module électronique relativement à ladite plaque, et **en ce qu'**une fente (48), située le long du bord de chaque module électronique, est prévue entre lesdites liaisons matérielles.

23. Ensemble selon la revendication 22, **caractérisé en ce que** ladite fente (48) est prévue le long de la majeure partie dudit bord de chaque module électronique.

24. Ensemble selon l'une des revendications 21 à 23, **caractérisé en ce qu'**un film de colle (78) est agencé entre ladite au moins une zone de chaque module électronique et ladite au moins une partie correspondante de la région périphérique de l'ouverture correspondante de ladite plaque, ce film de colle constituant une interface d'adhérence.

25. Ensemble selon l'une des revendications 21 à 24, **caractérisé en ce que** l'épaisseur de ladite plaque est prévue sensiblement identique à la hauteur maximale du ou des module(s) électronique(s), chaque module étant sensiblement situé entièrement dans l'ouverture correspondante de ladite plaque.

26. Produit intermédiaire pour un procédé de fabrication de cartes dans lequel il forme une couche centrale de ces cartes, ce produit intermédiaire étant **caractérisé en ce qu'**il est formé d'un ensemble selon la revendication 21 et d'un matériau de remplissage (60) qui remplit l'espace restant dans chaque ouverture.

27. Produit intermédiaire selon la revendication 26, **caractérisé en ce que** chaque ouverture présente des premières dimensions et un premier profil et chaque module électronique présente des deuxièmes dimensions et un deuxième profil qui sont prévus de manière qu'au moins deux zones distinctes dudit bord de ce module électronique soient superposées à au moins deux parties correspondantes de ladite région périphérique de l'ouverture correspondante, chaque zone et la partie correspondante formant conjointement une liaison matérielle entre ce module électronique et ladite plaque et assurant un positionnement précis dudit module électronique relativement à ladite plaque, et **en ce qu'**une fente (48), située le long du bord de chaque module électronique, est prévue entre lesdites liaisons matérielles, cette fente étant remplie par ledit matériau de remplissage (60).

28. Produit intermédiaire selon la revendication 27, **caractérisé en ce que** ladite fente (48) est prévue le long de la majeure partie dudit bord de chaque module électronique.

29. Produit intermédiaire selon l'une des revendications 26 à 28, **caractérisé en ce qu'**un film de colle est agencé entre ladite au moins une zone de chaque module électronique et ladite au moins une partie correspondante de la région périphérique de l'ouverture correspondante de ladite plaque, ce film de colle constituant une interface d'adhérence.

30. Produit intermédiaire selon l'une des revendications 26 à 29, **caractérisé en ce que** l'épaisseur de ladite plaque est prévue sensiblement identique à la hauteur maximale du ou des module(s) électronique(s), chaque module étant sensiblement situé entièrement dans l'ouverture correspondante de ladite plaque.

31. Produit intermédiaire selon l'une des revendications 26 à 30, caractérisé en ce ledit matériau de remplissage (60) est formé par une résine adhérant solidement aux matériaux PVC, cette résine recouvrant également la face inférieure et la face supérieure de ladite plaque.

## Claims

1. Method of manufacturing at least one card each including an electronic module (2; 2A; 2B; 3), said method providing a frame (14) or a plate (18; 18A; 18B; 70) having at least one through aperture (16; 16A; 16B; 71) into which said electronic module is inserted, and a filling material (60) for filling a space remaining in said at least one through aperture, said method being **characterized in that** at least one part (20, 21; 20A, 21A; 20B, 21B; 20C, 21C; 85) of the peripheral area of said at least one aperture is deformed or crushed by the application of pressure, localised at said at least one part of the peripheral area, on said frame or said plate, so as to reduce the thickness of said frame or said plate locally in said at least one part of the peripheral area, **in that** said electronic module is brought opposite said at least one aperture so that at least one zone (30, 31; 30A, 31A; 30B, 31B; 30C, 31C) of said electronic module is superposed on said at least one part of the peripheral area, and **in that** a material connection is set up between said at least one part of the peripheral area of said frame or said plate and said at least one zone of said electronic module, before said filling material (60) is added in a subsequent step of the method.

2. Method according to claim 1, **characterized in that** said localised application of pressure is achieved using a press (72) before said at least one electronic module is brought opposite said at least one aperture, said at least one deformed or crushed part defining at least one step (74, 76) on which said at least one zone of the electronic module is then placed.

3. Method according to claim 1, **characterized in that** said electronic module is brought opposite said at least one corresponding aperture before said localised application of pressure, said at least one zone of the electronic module then being pressed against said at least one part of said peripheral area so as to crush or deform said at least one part and thus make said electronic module move at least slightly deeper into said at least one aperture.

4. Manufacturing method according to any of the preceding claims, **characterized in that** said electronic module includes an electronic display element (6).

5. Method according to any of the preceding claims, **characterized in that** said localised application of pressure is carried out without adding localised heat to said at least one part of the peripheral area of said frame or said plate.

6. Method according to claim 5, **characterized in that** said localised application of pressure is carried out approximately at ambient temperature.

7. Manufacturing method according to any of claims 1 to 4, **characterized in that** said deformation of said part of the peripheral area of said at least one aperture is obtained by localised thermocompression.

8. Manufacturing method according to any of the preceding claims, **characterized in that** at least one said zone or one said part of the peripheral area of said at least one aperture is coated with adhesive (78), before said electronic module is assembled to said frame or said plate, to form an adherent film between said zone and the corresponding part.

9. Manufacturing method according to any of the preceding claims, wherein said electronic module is arranged in a single aperture, said aperture having first dimensions and a first profile and said electronic module having second dimensions and a second profile, **characterized in that** said first dimensions and said first profile of said aperture and said second dimensions and said second profile of said electronic module are such that at least two distinct zones of said edge of the electronic module are superposed on as many corresponding parts of said peripheral area of the aperture, the localised application of pressure being carried out on said corresponding parts, each of the zones and the part that corresponds thereto forming a rigid connection between the electronic module and the frame or the plate after said two elements have been assembled.

10. Method according to claim 9, **characterized in that** said at least one part of said peripheral area is formed by a projecting part (20, 21) relative to the general profile of said at least one aperture.

11. Method according to claim 9, **characterized in that** said at least one part of the peripheral area is formed by a truncated corner of said aperture or by a projecting angular portion (20B, 21 B) relative to the general profile of said aperture.

12. Method according to any of claims 9 to 11, **characterized in that** said at least one zone of the edge of said electronic module is formed by a projecting portion (30A, 31A) relative to the general external profile of said electronic module.

13. Method according to any of claims 9 to 12, **characterized in that** said first dimensions, said first profile, said second dimensions and said second profile are such that a slot (48) remains between said electronic module and said aperture along most of said edge of said electronic module.

14. Method according to any of the preceding claims, **characterized in that** the thickness of said frame or said plate is approximately identical to the maximum height of said electronic module, said electronic module being arranged in said at least one aperture such that said module is more or less entirely located between the bottom flat and the top flat defined by said frame or said plate.

15. Method according to any of the preceding claims, **characterized in that** a resin (60) is provided to form a layer incorporating said frame or said plate and said electronic module of each card.

16. Method according to claim 15, **characterized in that** said filling material is formed by said resin.

17. Method according to claim 15 or 16, **characterized in that** the bottom surface and the top surface of said frame or said plate are covered by said resin.

18. Method according to any of claims 15 to 17, **characterized in that** the product obtained forms an intermediate product with a bottom surface and a top surface which are approximately flat.

19. Method according to claim 17, **characterized in that** at least two solid layers are respectively added to the two sides of said open plate assembled to electronic modules and to said resin, which is in a viscous state, each card obtained after the resin has solidified thus having two external layers.

20. Method according to claim 4 and any of claims 15 to 19, **characterized in that** said resin covers said display element and **in that** said resin is transparent.

21. Assembly for a card manufacturing method, wherein said assembly is first formed and then at least partially covered by a filling material or a resin to form, with said filling material or said resin, a layer of the cards, said assembly being **characterized in that** it is formed of a plate (18; 18A; 18B; 70) having one or several through apertures (16; 16A; 16B; 71), one or several electronic module(s) (2; 2A; 2B; 3) being housed in said aperture or apertures which each has or have an open space remaining on at least one side of said plate, each electronic module having at least one zone (30, 31; 30A, 31A; 30B, 318; 30C, 31C) superposed on and secured to at least one part (20, 21; 20A, 21 A; 20B, 21B; 20C, 21C; 85) of the peripheral area of a corresponding aperture in the plate, said at least one zone and said at least one part thereby jointly forming a material connection between said electronic module and said plate, and **in that** the height of said at least one part of the peripheral area of each aperture is less than the thickness of said plate.

22. Assembly according to claim 21, **characterized in that** each aperture in said plate has first dimensions and a first profile and each electronic module has second dimensions and a second profile, which are such that at least two distinct zones of the edge of said electronic module are superposed on at least two corresponding parts of said peripheral area of the corresponding aperture, each zone and the corresponding part jointly forming a material connection between said electronic module and said plate and thus positioning the electronic module relative to said plate and **in that** a slot (48), located along the edge of each electronic module, is arranged between said material connections.

23. Assembly according to claim 22, **characterized in that** said slot (48) is arranged along most of said edge of each electronic module.

24. Assembly according to any of claims 21 to 23, **characterized in that** an adhesive film (78) is arranged between said at least one zone of each electronic module and said at least one corresponding part of the peripheral area of the corresponding aperture in said plate, said adhesive film forming an adherent interface.

25. Assembly according to any of claims 21 to 24, **characterized in that** the thickness of said plate is approximately identical to the maximum height of the electronic module(s), each module being approximately located entirely inside the corresponding aperture in said plate.

26. Intermediate product for a card manufacturing method wherein said product forms a central layer of said cards, said intermediate product being **characterized in that** it is formed of an assembly according to claim 21 and a filling material (60) which fills the remaining space in each aperture.

27. intermediate product according to claim 26, **characterized in that** each aperture has first dimensions and a first profile and each electronic module has second dimensions and a second profile, which are such that at least two distinct zones of said edge of said electronic module are superposed on at least two corresponding parts of said peripheral area of the corresponding aperture, each zone and the corresponding part jointly forming a material connection between said electronic module and said plate and precisely positioning said electronic module relative to said plate and **in that** a slot (48), located along the edge of each electronic module, is arranged between said material connections, said slot being filled by said filling material (60).

28. intermediate product according to claim 27, **characterized in that** said slot (48) is arranged along most of said edge of each electronic module.

29. Intermediate product according to any of claims 26 to 28, **characterized in that** an adhesive film is deposited between said at least one zone of each electronic module and said at least one corresponding part of the peripheral area of the corresponding aperture in said plate, said adhesive film forming an adherent interface.

30. Intermediate product according to any of claims 26 to 29, **characterized in that** the thickness of said plate is approximately identical to the maximum height of the electronic module(s), each module being located more of less entirely inside the corresponding aperture in said plate.

31. Intermediate product according to any of claims 26 to 30, **characterized in that** said filling material (60) is formed by a resin that adheres securely to PVC materials, said resin also covering the bottom surface and the top surface of said plate.

## Patentansprüche

1. Verfahren zur Herstellung mindestens einer Karte mit jeweils einem elektronischen Modul (2; 2A; 2B; 3), wobei dieses Verfahren die Bereitstellung eines Rahmens (14) oder einer Platte (18; 18A; 18B; 70), der/die mindestens eine Durchgangsöffnung (16; 16A; 16B; 71) aufweist, in die das elektronische Modul eingeführt wird, sowie die Bereitstellung eines Füllmaterials (60) zum Füllen eines in der mindestens einen Durchgangsöffnung verbleibenden Raums vorsieht, wobei dieses Verfahren **dadurch gekennzeichnet ist, dass** mindestens ein Teil (20, 21; 20A, 21A; 20B, 21B; 20C, 21C; 85) des Umfangsbereichs der mindestens einen Öffnung durch das Ausüben eines Drucks, der an diesem mindestens einen Teil des Umfangsbereichs lokalisiert ist, auf den Rahmen oder die Platte verformt oder gequetscht wird, um die Dicke des Rahmens oder der Platte in diesem mindestens einen Teil des Umfangsbereichs lokal zu verringern, dass das elektronische Modul gegenüber der mindestens einen Öffnung angeordnet wird, so dass mindestens eine Zone (30, 31; 30A, 31A, 30B, 31B; 30C, 31C) dieses elektronischen Moduls auf den mindestens einen Teil des Umfangsbereichs überlagert wird, und dass eine Materialverbindung zwischen diesem mindestens einen Teil des Umfangsbereichs des Rahmens oder der Platte und der mindestens einen Zone des elektronischen Moduls vor dem Zuführen des Füllmaterials (60) in einem späteren Schritt des Verfahrens hergestellt wird.

2. Verfahren nach Anspruch 1, **dadurch gekennzeichnet, dass** das Ausüben eines lokalisierten Drucks mit Hilfe einer Presse (72) durchgeführt wird, bevor das mindestens eine elektronische Modul gegenüber der mindestens einen Öffnung angeordnet wird, wobei der mindestens eine verformte oder gequetschte Teil mindestens eine Stufe (74, 76) definiert, auf der anschließend die mindestens eine Zone des elektronischen Moduls angeordnet wird.

3. Verfahren nach Anspruch 1, **dadurch gekennzeichnet, dass** das Anordnen des elektronischen Moduls gegenüber der mindestens einen entsprechenden Öffnung vor dem Ausüben eines lokalisierten Drucks durchgeführt wird, wobei die mindestens eine Zone des elektronischen Moduls anschließend gegen den mindestens einen Teil des Umfangsbereichs gepresst wird, um diesen mindestens einen Teil zu quetschen oder zu verformen und somit das elektronische Modul zumindest etwas tiefer in die mindestens eine Öffnung eindringen zu lassen.

4. Herstellungsverfahren nach einem der vorangehenden Ansprüche, **dadurch gekennzeichnet, dass** das elektronische Modul ein elektronisches Anzeigeelement (6) umfasst.

5. Verfahren nach einem der vorangehenden Ansprüche, **dadurch gekennzeichnet, dass** das Ausüben eines lokalisierten Drucks ohne Zuführen von lokalisierter Wärme zu dem mindestens einen Teil des Umfangsbereichs des Rahmens oder der Platte durchgeführt wird.

6. Verfahren nach Anspruch 5, **dadurch gekennzeichnet, dass** das Ausüben eines lokalisierten Drucks im Wesentlichen bei Umgebungstemperatur durchgeführt wird.

7. Herstellungsverfahren nach einem der Ansprüche 1 bis 4, **dadurch gekennzeichnet, dass** die Verformung des Teils des Umfangsbereichs der mindestens einen Öffnung durch eine lokalisierte Thermokornpression erhalten wird.

8. Herstellungsverfahren nach einem der vorangehenden Ansprüche, **dadurch gekennzeichnet, dass** mindestens eine genannte Zone oder ein genannter Teil des Umfangsbereichs der mindestens einen Öffnung vor dem Zusammenfügen des elektronischen Moduls mit dem Rahmen oder der Platte mit Klebstoff (78) überzogen wird, um einen Haftfilm zwischen dieser Zone und dem entsprechenden Teil zu bilden.

9. Herstellungsverfahren nach einem der vorangehenden Ansprüche und in dem das elektronische Modul in einer einzigen Öffnung angeordnet wird, wobei diese Öffnung erste Abmessungen und ein erstes Profil aufweist und dieses elektronische Modul zweite Abmessungen und ein zweites Profil aufweist, **dadurch gekennzeichnet, dass** die ersten Abmessungen und das erste Profil dieser Öffnung und die zweiten Abmessungen und das zweite Profil dieses elektronischen Moduls so vorgesehen sind, dass mindestens zwei unterschiedliche Zonen des Randes des elektronischen Moduls auf so viele entsprechende Teile des Umfangsbereichs der Öffnung überlagert werden, wobei das Ausüben eines lokalisierten Drucks auf diese entsprechenden Teile durchgeführt wird, wobei jede der Zonen und der ihr entsprechende Teil eine starre Verbindung zwischen dem elektronischen Modul und dem Rahmen oder der Platte nach dem Zusammenfügen dieser zwei Elemente bilden.

10. Verfahren nach Anspruch 9, **dadurch gekennzeichnet, dass** der mindestens eine Teil des Umfangsbereichs durch einen Vorsprung (20, 21) in Bezug auf das allgemeine Profil der mindestens einen Öffnung gebildet wird.

11. Verfahren nach Anspruch 9, **dadurch gekennzeichnet, dass** der mindestens eine Teil des Umfangsbereichs durch einen stumpfen Winkel der Öffnung oder durch einen vorstehenden Winkelteil (208, 21B) in Bezug auf das allgemeine Profil dieser Öffnung gebildet wird.

12. Verfahren nach einem der Ansprüche 9 bis 11, **dadurch gekennzeichnet, dass** die mindestens eine Zone des Randes des elektronischen Moduls durch einen Vorsprung (30A, 31A) in Bezug auf das allgemeine äußere Profil dieses elektronischen Moduls gebildet wird.

13. Verfahren nach einem der Ansprüche 9 bis 12, **dadurch gekennzeichnet, dass** die ersten Abmessungen, das erste Profil, die zweiten Abmessungen und das zweite Profil so vorgesehen sind, dass ein Schlitz (48) zwischen dem elektronischen Modul und der Öffnung entlang des Hauptteils des Randes dieses elektronischen Moduls verbleibt.

14. Verfahren nach einem der vorangehenden Ansprüche, **dadurch gekennzeichnet, dass** die Dicke des Rahmens oder der Platte im Wesentlichen identisch zur maximalen Höhe des elektronischen Moduls vorgesehen ist, wobei dieses elektronische Modul in der mindestens einen Öffnung so angeordnet wird, dass es im Wesentlichen vollständig zwischen der unteren Ebene und der oberen Ebene, die durch den Rahmen oder die Platte definiert sind, liegt.

15. Verfahren nach einem der vorangehenden Ansprüche, **dadurch gekennzeichnet, dass** ein Harz (60) zum Ausbilden einer Schicht, die den Rahmen oder die Platte und das elektronische Modul jeder Karte einschließt, zugeführt wird.

16. Verfahren nach Anspruch 15, **dadurch gekennzeichnet, dass** das Füllmaterial aus dem Harz gebildet ist.

17. Verfahren nach Anspruch 15 oder 16, **dadurch gekennzeichnet, dass** die untere Oberfläche und die obere Oberfläche des Rahmens oder der Platte mit dem Harz bedeckt werden.

18. Verfahren nach einem der Ansprüche 15 bis 17, **dadurch gekennzeichnet, dass** das erhaltene Produkt ein Zwischenprodukt bildet, das eine Unterseite und eine Oberseite aufweist, die im Wesentlichen eben sind.

19. Verfahren nach Anspruch 17, **dadurch gekennzeichnet, dass** mindestens zwei feste Schichten jeweils auf den zwei Seiten der offenen Platte, die mit elektronischen Modulen und dem Harz dann in einem viskosen Zustand zusammengefügt wird, bereitgestellt werden, wobei jede erhaltene Karte nach Verfestigung des Harzes somit zwei äußere Schichten aufweist.

20. Verfahren nach Anspruch 4 und einem der Ansprüche 15 bis 19, **dadurch gekennzeichnet, dass** das Harz das Anzeigeelement bedeckt und dass es transparent vorgesehen ist.

21. Einheit für ein Verfahren zur Herstellung von Karten, bei dem diese Einheit zuerst ausgebildet und anschließend zumindest teilweise mit einem Füllmaterial oder einem Harz überzogen wird, um mit diesem Füllmaterial oder diesem Harz eine Schicht für Karten zu bilden, wobei diese Einheit **dadurch gekennzeichnet ist, dass** sie gebildet ist aus einer Platte (18; 18A; 18B; 70), die eine oder mehrere Durchgangsöffnung(en) (16; 16A; 16B; 71) aufweist, einem oder mehreren elektronischen Modul(en) (2; 2A; 2B; 3), die in dieser oder diesen Öffnung(en) aufgenommen ist (sind), die jeweils einen Raum aufweist (aufweisen), der zumindest auf einer Seite der Platte offen bleibt, wobei jedes elektronische Modul mindestens eine Zone (30, 31; 30A, 31A; 30B, 31B; 30C, 31 C) aufweist, die auf mindestens einen Teil (20, 21; 20A, 21 A; 20B, 21B; 20C, 21C; 85) des Umfangsbereichs einer entsprechenden Öffnung der Platte überlagert und daran befestigt ist, wobei die mindestens eine Zone und der mindestens eine Teil somit gemeinsam eine Materialverbindung zwischen diesem elektronischen Modul und der Platte bilden, und dass der mindestens eine Teil des Umfangsbereichs jeder Öffnung eine Höhe aufweist, die geringer ist als die Dicke der Platte.

22. Einheit nach Anspruch 21, **dadurch gekennzeichnet, dass** jede Öffnung der Platte erste Abmessungen und ein erstes Profil aufweist und jedes elektronische Modul zweite Abmessungen und ein zweites Profil aufweist, die so vorgesehen sind, dass mindestens zwei unterschiedliche Zonen des Randes dieses elektronischen Moduls auf mindestens zwei entsprechende Teile des Umfangsbereichs der entsprechenden Öffnung überlagert sind, wobei jede Zone und der entsprechende Teil gemeinsam eine Materialverbindung zwischen diesem elektronischen Modul und der Platte bilden und somit die Positionierung des elektronischen Moduls in Bezug auf die Platte sicherstellen, und dass ein Schlitz (48), der sich entlang des Randes jedes elektronischen Moduls befindet, zwischen den Materialverbindungen vorgesehen ist.

23. Einheit nach Anspruch 22, **dadurch gekennzeichnet, dass** der Schlitz (48) entlang des Hauptteils des Randes jedes elektronischen Moduls vorgesehen ist.

24. Einheit nach einem der Ansprüche 21 bis 23, **dadurch gekennzeichnet, dass** ein Klebstofffilm (78) zwischen der mindestens einen Zone jedes elektronischen Moduls und dem mindestens einen entsprechenden Teil des Umfangsbereichs der entsprechenden Öffnung der Platte angeordnet ist, wobei dieser Klebstofffilm eine Haftgrenzfläche bildet.

25. Einheit nach einem der Ansprüche 21 bis 24, **dadurch gekennzeichnet, dass** die Dicke der Platte im Wesentlichen identisch zur maximalen Höhe des oder der elektronische(n) Moduls (Module) vorgesehen ist, wobei jedes Modul im Wesentlichen vollständig in der entsprechenden Öffnung der Platte liegt.

26. Zwischenprodukt für ein Verfahren zur Herstellung von Karten, bei dem es eine zentrale Schicht dieser Karten bildet, wobei dieses Zwischenprodukt **dadurch gekennzeichnet ist, dass** es aus einer Einheit nach Anspruch 21 und einem Füllmaterial (60), das den in jeder Öffnung verbleibenden Raum füllt, gebildet ist.

27. Zwischenprodukt nach Anspruch 26, **dadurch gekennzeichnet, dass** jede Öffnung erste Abmessungen und ein erstes Profil aufweist und jedes elektronische Modul zweite Abmessungen und ein zweites Profil aufweist, die so vorgesehen sind, dass mindestens zwei unterschiedliche Zonen des Randes dieses elektronischen Moduls auf mindestens zwei entsprechende Teile des Umfangsbereichs der entsprechenden Öffnung überlagert sind, wobei jede Zone und der entsprechende Teil gemeinsam eine Materialverbindung zwischen diesem elektronischen Modul und der Platte bilden und eine genaue Positionierung des elektronischen Moduls in Bezug auf die Platte sicherstellen, und dass ein Schlitz (48), der entlang des Randes jedes elektronischen Moduls liegt, zwischen den Materialverbindungen vorgesehen ist, wobei dieser Schlitz mit dem Füllmaterial (60) gefüllt ist.

28. Zwischenprodukt nach Anspruch 27, **dadurch gekennzeichnet, dass** der Schlitz (48) entlang des Hauptteils des Randes jedes elektronischen Moduls vorgesehen ist.

29. Zwischenprodukt nach einem der Ansprüche 26 bis 28, **dadurch gekennzeichnet, dass** ein Klebstofffilm zwischen der mindestens einen Zone jedes elektronischen Moduls und dem mindestens einen entsprechenden Teil des Umfangsbereichs der entsprechenden Öffnung der Platte angeordnet ist, wobei dieser Klebstofffilm eine Haftgrenzfläche bildet.

30. Zwischenprodukt nach einem der Ansprüche 26 bis 29, **dadurch gekennzeichnet, dass** die Dicke der Platte im Wesentlichen identisch zur maximalen Höhe des oder der elektronischen Moduls (Module) vorgesehen ist, wobei jedes Modul im Wesentlichen vollständig in der entsprechenden Öffnung der Platte liegt.

31. Zwischenprodukt nach einem der Ansprüche 26 bis 30, **dadurch gekennzeichnet, dass** das Füllmaterial (60) aus einem Harz gebildet ist, das fest an den PVC-Materialien haftet, wobei dieses Harz auch die Unterseite und die Oberseite der Platte bedeckt.
